(19) Europäisches Patentamt
European Patent Office
Office européen des brevets

(11) **EP 3 654 048 A1**

(12) # DEMANDE DE BREVET EUROPEEN

(43) Date de publication:
**20.05.2020 Bulletin 2020/21**

(51) Int Cl.:
***G01R 33/24*** *(2006.01)*

(21) Numéro de dépôt: **19208978.7**

(22) Date de dépôt: **13.11.2019**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **16.11.2018 FR 1860642**

(71) Demandeur: **Commissariat à l'énergie atomique et aux énergies alternatives**
**75015 Paris (FR)**

(72) Inventeur: **BEATO, François**
**38054 GRENOBLE cedex 09 (FR)**

(74) Mandataire: **Brevalex**
**95, rue d'Amsterdam**
**75378 Paris Cedex 8 (FR)**

(54) **MAGNÉTOMÈTRE EN ALIGNEMENT À DÉCALAGE ANGULAIRE ENTRE POLARISATIONS DES FAISCEAUX DE POMPE ET DE SONDE**

(57) L'invention porte sur un magnétomètre (10) comprenant une cellule (1) remplie d'un gaz atomique, une source optique (2, 3, 11-13) configurée pour éclairer la cellule avec un faisceau de pompe (Fp) et un faisceau de sonde (Fs) et un dispositif de photo-détection (6) agencé de manière à recevoir la lumière du faisceau de sonde ayant traversée la cellule et configuré pour délivrer un signal porteur d'une information relative à l'état d'alignement des atomes du gaz atomique dans la cellule.

Le faisceau de pompe (Fp) est polarisé linéairement selon une direction de polarisation et le faisceau de sonde (Fs) est polarisé linéairement selon une direction de polarisation faisant un angle non nul avec la direction de polarisation du faisceau de pompe.

FIG. 1

EP 3 654 048 A1

**Description**

**DOMAINE TECHNIQUE**

Le domaine de l'invention est celui des magnétomètres à pompage optique. L'invention trouve plus particulièrement, mais non exclusivement, application pour les magnétomètres à résonance paramétrique.

**ÉTAT DE LA TECHNIQUE ANTÉRIEURE**

Les magnétomètres à pompage optique utilisent des gaz atomiques confinés dans une cellule, typiquement de l'hélium métastable ou des gaz d'alcalins, en tant qu'élément sensible. Ces magnétomètres, qui peuvent prendre différentes configurations, permettent de remonter au champ magnétique en exploitant les trois processus suivants qui ont lieu de façon soit séquentielle soit concomitante :

   1) L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.
   2) Ces états atomiques évoluent sous l'effet du champ magnétique, notamment sous l'effet Zeeman qui correspond à des décalages des niveaux d'énergie en fonction du champ magnétique auquel sont soumis les atomes.
   3) Les propriétés optiques du milieu atomique subissent alors des modifications qui dépendent de l'état des atomes. On peut ainsi par une mesure optique, par exemple par une mesure d'absorption optique, remonter au décalage Zeeman subi et en déduire une mesure du champ magnétique dans lequel est plongée la cellule.

Selon les différentes configurations possibles des magnétomètres à pompage optique existants, on distingue une mesure du module, aussi appelée norme, du champ magnétique pour les magnétomètres scalaires, ou une détermination des différentes composantes du champ magnétique à l'emplacement de la cellule pour les magnétomètres vectoriels.

Pour réaliser une mesure vectorielle du champ magnétique avec une bande passante large, il existe deux configurations bien connues : la première dite « à effet Hanle » et la deuxième dite « à résonance paramétrique ». Ces configurations sont décrites notamment dans l'article de J. Dupont-Roc, "Détermination par des méthodes optiques des trois composantes d'un champ magnétique très faible," Revue de Physique Appliquée, vol. 5, no. 6, pp. 853-864, 1970. Elles fonctionnent à des valeurs de champ magnétique extérieur très faibles, induisant un décalage Zeeman plus faible que le taux de relaxation des sous-niveaux Zeeman de l'atome, ce qui pour le cas de l'hélium fixe une limite autour de 100 nano Tesla, soit 500 fois moins intense que le champ magnétique terrestre.

La différence entre ces deux configurations vient de l'application (en résonance paramétrique) ou non (effet Hanle) d'un ou deux champs de radiofréquence (RF) qui permettent de moduler la réponse du système.

Dans la plupart des travaux antérieurs, la mesure optique est basée sur une mesure d'absorption. Pour ce type de mesure, le rapport signal à bruit optimal est obtenu en calant la longueur d'onde du faisceau réalisant la mesure (faisceau sonde) au centre d'une des raies atomiques du gaz utilisé. Dans ce cas, il est possible de confondre le faisceau réalisant le pompage optique (faisceau pompe) avec le faisceau sonde, si l'on choisit de pomper et de sonder via la même raie atomique. Des mesures médicales utilisant un magnétomètre à résonance paramétrique utilisant de l'hélium-4 pompé en alignement ont montré qu'à l'heure actuelle, la sensibilité du capteur est limitée par les bruits techniques du laser (cf. « Magnetocardiography measurements with 4He vector optically pumped magnetometers at room temperature », Morales et al, 2017 Phys. Med. Biol. 62 7267).

Dans le cas de magnétomètres exploitant des gaz d'alcalins pompés en orientation à l'aide d'un faisceau de pompe polarisé circulairement, différents documents (dont par exemple J. C. Allred et al., "High-Sensitivity Atomic Magnetometer Unaffected by Spin-Exchange Relaxation," Phys. Rev. Lett., vol. 89, no. 13, p. 130801, Sep. 2002) décrivent un autre type de mesure optique. Cette mesure consiste à envoyer un deuxième faisceau polarisé linéairement et légèrement décalé en longueur d'onde par rapport à une transition atomique. Dans ce cas, le signal de mesure qui permet de remonter à la dynamique atomique est l'angle de rotation du plan de polarisation de la lumière.

Cette mesure polarimétrique présente l'avantage d'être une mesure différentielle, ce qui permet de s'affranchir de nombreux bruits techniques. Toutefois, la rotation de l'angle de polarisation de la lumière qui est utilisée comme signal de mesure est toujours nulle dans le cas où les atomes sont alignés sous l'effet d'un pompage en polarisation linéaire, comme c'est le cas notamment dans l'article Morales et al. cité plus haut.

Or il peut être préféré de réaliser un tel pompage en polarisation linéaire afin de passer outre des effets indésirables d'un pompage en polarisation circulaire qui introduisent des défauts significatifs dans le fonctionnement d'un magnétomètre, notamment l'effet connu comme « light-shift » ou « AC-Stark shift » selon lequel une lumière polarisée circulairement et non parfaitement accordée à une transition atomique se comporte comme un champ magnétique fictif perturbant le comportement des atomes.

## EXPOSÉ DE L'INVENTION

L'invention a pour objectif de réaliser une mesure polarimétrique différentielle d'un état d'alignement des atomes obtenu au moyen d'un pompage en polarisation linéaire. A cet effet, l'invention propose un magnétomètre comprenant une cellule remplie d'un gaz atomique, une source optique configurée pour éclairer la cellule avec un faisceau de pompe et un faisceau de sonde et un dispositif de photo-détection agencé de manière à recevoir la lumière du faisceau de sonde ayant traversée la cellule et configuré pour délivrer un signal porteur d'une information relative à l'état d'alignement des atomes du gaz atomique dans la cellule. Le faisceau de pompe est polarisé linéairement selon une direction de polarisation et le faisceau de sonde est polarisé linéairement selon une direction de polarisation faisant un angle non nul avec la direction de polarisation du faisceau de pompe.

Certains aspects préférés mais non limitatifs de ce magnétomètre sont les suivants :

- le faisceau de sonde se propage selon l'axe z d'un trièdre Oxyz, le faisceau de pompe est polarisé linéairement selon l'axe x du trièdre et le faisceau de pompe est polarisé linéairement dans le plan Oxy en faisant ledit angle non nul avec l'axe x ;

  - ledit angle non nul est choisi de manière à ce que ce que le signal délivré par le dispositif de photo-détection soit nul en présence d'un champ magnétique ambiant nul ;
  - ledit angle non nul est compris entre 45° et 90° ;
  - le faisceau de pompe est accordé en longueur d'onde au centre d'une première raie atomique et le faisceau de sonde est accordé en longueur d'onde de manière à être décalé du centre d'une deuxième raie atomique différente de la première raie atomique en étant par exemple accordé au maximum de la partie imaginaire du profil de Voigt de la deuxième raie atomique ;
  - le faisceau de pompe est accordé en longueur d'onde au centre d'une première raie atomique et le faisceau de sonde est accordé en longueur d'onde de manière à être décalé du centre de la première raie atomique en étant par exemple accordé en longueur d'onde au maximum de la partie imaginaire du profil de Voigt de la première raie atomique ;
  - il comprend en outre une source d'excitation de résonance paramétrique et le dispositif de photo-détection comprend un analyseur de polarisation configuré pour réaliser une mesure différentielle de la polarisation circulaire droite et de la polarisation circulaire gauche du faisceau de sonde ayant traversée la cellule ;
  - l'analyseur de polarisation comprend une lame quart d'onde, un séparateur de polarisations apte à séparer sur un premier et un deuxième chemin la polarisation circulaire droite et la polarisation circulaire gauche de la contribution de sonde ayant traversée la cellule et un photodétecteur sur chacun des premier et deuxième chemins.
  - le dispositif de photo-détection est configuré pour réaliser une mesure d'absorption du faisceau de sonde lors de la traversée de la cellule ;
  - il comprend en outre un modulateur du faisceau de sonde.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est un schéma d'un magnétomètre conforme à l'invention ;
- la figure 2 est un schéma d'un exemple de disposition des directions de polarisation des faisceaux de pompe et de sonde ;
- la figure 3 représente le profil de Voigt d'une raie de transition atomique de l'hélium-4;
- la figure 4 représente un signal issu d'une mesure différentielle pouvant être réalisée dans l'invention.

## EXPOSÉ DÉTAILLÉ DE MODES DE RÉALISATION PARTICULIERS

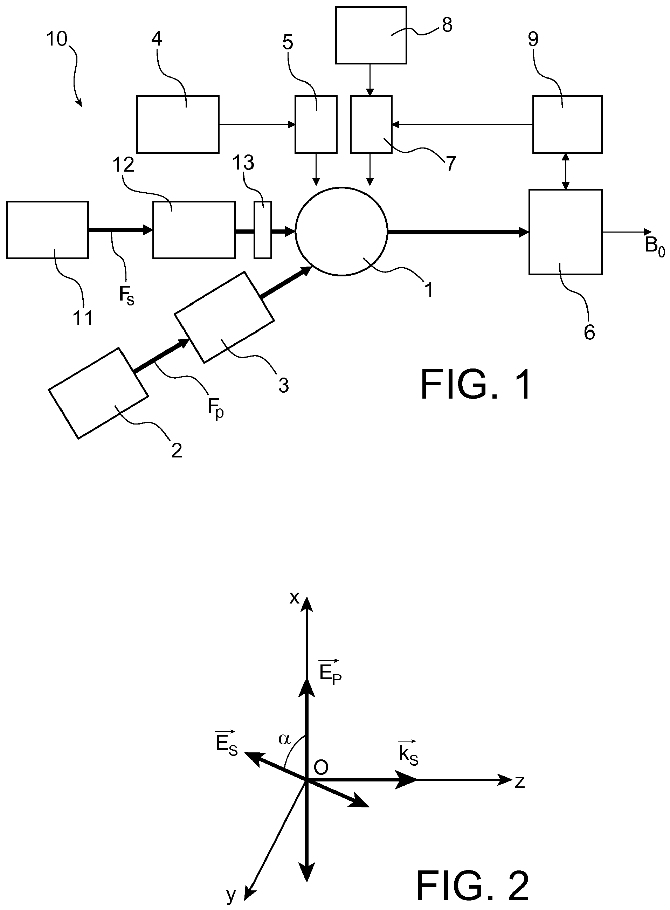

En référence à la figure 1, l'invention porte sur un magnétomètre vectoriel à pompage optique 10 qui comprend une cellule 1 remplie d'un gaz atomique apte à être polarisé en alignement, par exemple de l'hélium-4 ou un gaz alcalin, et qui est soumis à un champ magnétique ambiant $B_0$. Le magnétomètre 10 comprend par ailleurs une source optique 2, 3, 11-13 configurée pour éclairer la cellule et un détecteur 6 qui reçoit une lumière ayant traversée la cellule et délivre un signal porteur d'une information relative à l'état d'alignement des atomes du gaz atomique dans la cellule à une électronique de traitement qui exploite ce signal pour fournir une mesure du champ ambiant $B_0$.

Dans le cas où l'élément sensible est l'hélium-4, le magnétomètre 10 comporte par ailleurs un système de décharge haute fréquence (HF), comprenant un générateur HF 4 et des bobines de surtension 5, pour amener les atomes du gaz atomique dans un état énergisé où ils sont aptes à subir une transition atomique, typiquement dans l'état métastable $2^3S_1$.

Dans le cadre de l'invention, la source optique est configurée pour éclairer la cellule avec un faisceau de pompe et un faisceau de sonde. Le faisceau de pompe est polarisé linéairement ce qui induit des états atomiques dits « alignés » dans la cellule 1, l'axe d'alignement étant fixé par la direction du champ électrique de la lumière utilisée pour le pompage. Le faisceau de sonde est polarisé linéairement selon une direction de polarisation faisant un angle non nul avec la direction de polarisation du faisceau de pompe. A titre d'exemple, et en référence à la figure 2, la direction de propagation $\vec{k_s}$ du faisceau de sonde est alignée selon l'axe z d'un trièdre Oxyz, la direction de polarisation $E_p$ du faisceau de pompe est alignée selon l'axe x du trièdre et la direction de polarisation $E_s$ du faisceau de pompe s'étend dans le plan Oxy en faisant un angle non-nul $\alpha$ avec l'axe x.

Comme représenté sur la figure 1, la cellule est ainsi éclairée par une source optique qui comprend un élément de pompage 2 apte à émettre en direction de la cellule 1 le faisceau de pompe Fp et un élément de sondage 11 apte à émettre en direction de la cellule 1 le faisceau de sonde Fs. Ces éléments 2, 11 peuvent être des lasers, par exemple des diodes semi-conductrices.

Le faisceau de pompe Fp est polarisé linéairement selon l'axe x au moyen d'un dispositif de polarisation 3 intercalé entre l'élément de pompage 2 et la cellule 1 ou directement intégré à l'élément de pompage 2. Le faisceau de sonde Fs est polarisé linéairement selon l'axe x au moyen d'un dispositif de polarisation 12 intercalé entre l'élément de sondage 11 et la cellule 1 ou directement intégré à l'élément de sondage 12. Le faisceau de sonde Fs se propage selon l'axe z du trièdre xyz et on le fait passer à travers un rotateur de polarisation 13 avant qu'il ne pénètre dans la cellule 1, de manière à faire tourner sa polarisation dans le plan xOy, celle-ci présentant en sortie du rotateur l'angle $\alpha$ non-nul avec l'axe x.

Les directions de propagation des faisceaux de pompe et de sonde peuvent être colinéaires de sorte que le magnétomètre ne compte qu'un seul accès optique. Alternativement, ces direction de propagation sont orthogonales, ou présentent comme représenté sur la figure 1 un décalage angulaire tel que ces faisceaux présentent une zone de recouvrement au niveau de la cellule.

Dans un mode de réalisation de l'invention représenté sur la figure 1, le magnétomètre est un magnétomètre à résonance paramétrique doté d'un circuit d'excitation de résonance paramétrique qui comporte un générateur de radiofréquence 8 qui alimente des bobines de Helmholtz 7 d'axes orthogonaux qui entourent la cellule afin de générer un champ magnétique radiofréquence d'excitation des résonances paramétriques. On peut notamment prévoir une paire de bobines de Helmholtz 7 sur chacun des axes du magnétomètre de manière à générer un champ radiofréquence d'excitation présentant trois composantes orthogonales. Dans un exemple de réalisation, des bobines de Helmholtz sont utilisées pour appliquer un champ magnétique radiofréquence le long de l'axe z, ce champ présentant une amplitude de 2.5 $\mu$T et une fréquence suffisamment grande pour sortir du bruit basse fréquence du laser émettant le faisceau de sonde, par exemple une fréquence de 90 kHz.

Dans un autre mode de réalisation, le magnétomètre est un magnétomètre à effet Hanle qui n'est donc pas doté d'un tel circuit d'excitation de résonance paramétrique.

Le magnétomètre peut également comprendre un système d'asservissement en boucle fermé du magnétomètre pour venir constamment soumettre la cellule à un champ magnétique total nul. Le système d'asservissement comprend un régulateur 9 couplé à l'électronique de traitement qui injecte un courant dans des bobines de Helmholtz (les mêmes que celles utilisés par le circuit d'excitation de résonance paramétrique dans le cas du magnétomètre à résonance paramétrique) d'axes orthogonaux qui entourent la cellule 1 afin de générer un champ magnétique de compensation Bc tel que la somme Bc+B$_0$ est maintenue à zéro en permanence. Alternativement, le magnétomètre peut être opéré en boucle ouverte, sans compensation du champ ambiant.

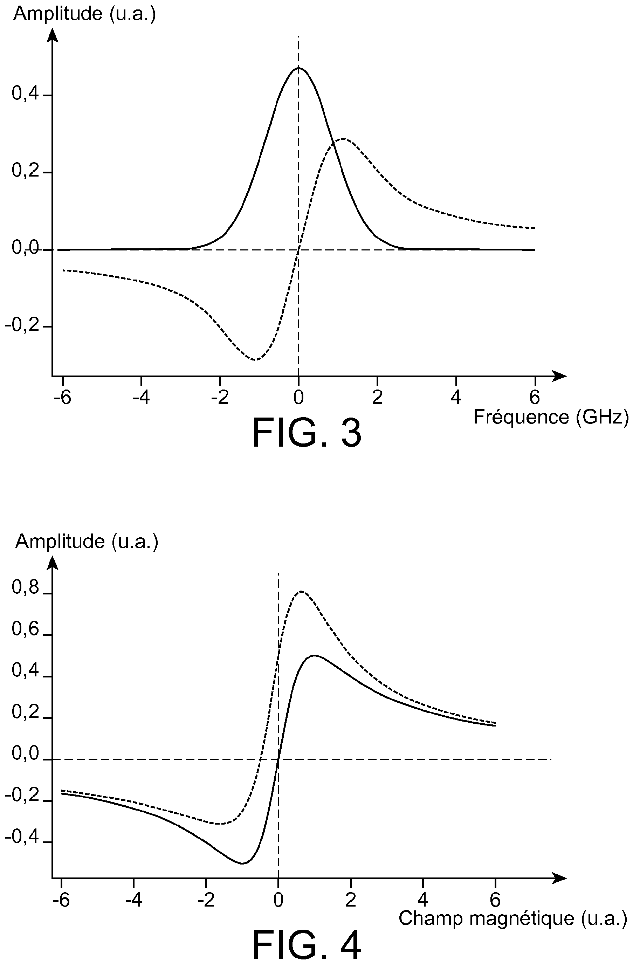

On a représenté sur la figure 3, le profil de Voigt de la raie de transition atomique D$_0$ de l'hélium-4 et plus particulièrement la partie réelle de ce profil en trait plein et la partie imaginaire de ce profil en trait pointillé. La partie réelle est représentative de l'intensité du pompage tandis que la partie imaginaire est représentative de l'intensité du signal de sonde. Sur cette figure, la raie est centrée sur la fréquence zéro, le maximum de la partie imaginaire est à 943,5 MHz du centre de la raie et les intensités sont reportées en unité arbitraire.

Sous l'effet du faisceau de pompe, les atomes du gaz atomique subissent une transition atomique. Le faisceau de pompe peut à cet effet être accordé en longueur d'onde au centre d'une raie de transition atomique, par exemple sur la raie D$_0$ à 1083 nm dans le cas de l'hélium-4. Par longueur d'onde accordée au centre d'une raie, on entend typiquement que la longueur d'onde est écartée du centre de la raie d'au plus la moitié de la largeur à mi-hauteur de la raie, soit à $\pm$ 0,85 Ghz du centre pour la raie D$_0$ de l'hélium.

Le faisceau de sonde subit quant à lui des variations de polarisation lors de la traversée de la cellule. Pour les raisons détaillées ci-après, sa longueur d'onde est idéalement rapprochée du centre de la raie atomique pour augmenter l'amplitude du signal photo-détecté. Le faisceau de sonde peut à cet effet être accordé en longueur d'onde au maximum de la partie imaginaire du profil de Voigt d'une raie de transition atomique (qui peut ou non être la même que celle utilisée pour le pompage), la longueur d'onde étant typiquement écartée de ce maximum d'au plus le quart de la largeur à mi-hauteur de la raie, soit à $\pm$ 0,45 Ghz de ce maximum pour la raie D$_0$ de l'hélium.

Lorsque les rôles des deux faisceaux sont parfaitement séparés (i.e. que la sonde ne pompe pas du tout les atomes, ce qui peut s'obtenir en éloignant suffisamment la longueur d'onde du faisceau de sonde par rapport à toute transition permettant le pompage), il est possible avec un angle $\alpha$ de 45° et un magnétomètre à résonance paramétrique d'obtenir un signal dit « dispersif » dans le domaine de la résonance magnétique. L'amplitude de ce signal, reportée en trait plein sur la figure 4 en unité arbitraire, est notamment caractérisée par une région linéaire en champ magnétique autour du champ magnétique nul, ce qui permet une mesure aisée d'un champ de faible amplitude (par exemple de 10 nT).

Cependant, l'amplitude du signal obtenu est proportionnelle à l'amplitude de la partie imaginaire du profil de Voigt de la transition atomique utilisée pour sonder, et décroit donc en $\frac{1}{\nu - \nu_0}$ lorsque la longueur d'onde du faisceau sonde est suffisamment loin du centre de la transition (où représente la longueur d'onde de la sonde et $\nu_0$ représente la longueur d'onde du centre de la transition atomique). Ainsi, afin d'augmenter l'amplitude du signal, on choisit de rapprocher la longueur d'onde du faisceau de sonde du centre de la raie. Cette longueur d'onde est alors typiquement écartée du centre de la raie d'au plus la largeur à mi-hauteur de la raie, et d'au moins un quart de cette largeur.

Dans ce cas cependant, on constate de la courbe en trait pointillé sur la figure 4 que le signal photo-détecté est déformé. Cette déformation est probablement due au fait qu'en se rapprochant du centre de la raie, la sonde se met également à pomper le gaz, et concurrence ainsi le pompage réalisé par le faisceau de pompe. Cette déformation est gênante notamment du fait que le point correspondant à un signal nul ne correspond plus à un champ magnétique nul, ce qui induit un décalage du zéro du magnétomètre.

La Demanderesse a néanmoins pu constater qu'il est possible dans le cas d'un magnétomètre à résonance paramétrique de choisir ledit angle non nul $\alpha$ de manière à ce que le signal délivré par le dispositif de photo-détection soit nul en présence d'un champ magnétique ambiant nul. Avec un tel angle, la déformation et le décalage du zéro sont annulés et il s'avère possible de retrouver une forme de signal parfaitement dispersive tout en bénéficiant d'une amplitude du signal plus importante et donc d'un meilleur rapport signal-à-bruit. En d'autres termes, le pompage réalisé par la sonde vient compléter le pompage de la pompe de manière à corriger le décalage susmentionné.

Dans le cas du magnétomètre à effet Hanle à absorption, on relèvera que le signal délivré par le dispositif de photo-détection présente un décalage continu dû à l'intensité du faisceau sonde qui traverse le gaz sans être absorbée, sur lequel se superpose le signal magnétique. Mais d'une façon générale, le signal nul que l'on cherche à obtenir en présence d'un champ magnétique ambiant nul correspond au signal démodulé à la fréquence de modulation du système (modulation obtenue par les RF pour la résonance paramétrique, ou par une modulation du faisceau de sonde pour le magnétomètre à effet Hanle).

La Demanderesse a notamment pu développer l'expression analytique suivante pour déterminer l'angle optimal de polarisation de la sonde dans le cas d'un magnétomètre à résonance paramétrique pour lequel un champ radiofréquence est appliqué sur l'axe z :

$$\Gamma_s + \Gamma_p \left(\cos[\alpha]\right)^2 - \Gamma_p \left(\sin[\alpha]\right)^2 = 0,$$

où $\Gamma_s$ et $\Gamma_p$ représentent l'élargissement de la raie de résonance dû au faisceau de sonde et au faisceau de pompe respectivement. En effet, « à puissance optique nulle » (c'est-à-dire à une puissance très faible de l'ordre de $1 \mu W$ pour l'hélium par exemple) la raie de résonance possède une largeur minimale (que nous appelons largeur naturelle $\Gamma_e$). Lorsque les différents faisceaux ont des puissances plus élevées, la raie de résonance est élargie. Sa largeur totale devient alors $\Gamma_{tot} = \Gamma_s + \Gamma_p + \Gamma_e$. Typiquement, on choisit $\Gamma_{tot}$ entre $\Gamma_e$ et $4\Gamma_e$. Dans le cas limite $\Gamma_{tot} = 4\Gamma_e$, et lorsque les deux faisceaux pompent de façon équivalente ($\Gamma_s = \Gamma_p$), il faut placer la polarisation de la sonde à un angle $\alpha = 90°$. Au-delà ($\Gamma_{probe} > \Gamma_{pump}$), il n'est plus possible de retrouver un signal parfaitement dispersif.

Dans un exemple de réalisation, la longueur d'onde du faisceau de pompe est ajustée au centre de la raie $D_0$ de l'hélium à 1083,205 nm dans le vide et la longueur d'onde du faisceau de sonde est ajustée au maximum de la partie imaginaire du profil de Voigt de cette raie, soit à 943,5 Mhz du centre de la raie. Les puissances optiques des faisceaux de pompe et de sonde sont ajustées de manière à ce que le taux de pompage du faisceau de pompe soit deux fois plus important que le taux de pompage du faisceau de sonde ($\Gamma_p = 2\Gamma_s$), ce qui conduit à avoir une puissance du faisceau de sonde 1,175 fois plus important que la puissance du faisceau de pompe. Afin d'obtenir un signal parfaitement dispersif, il convient alors d'utiliser un angle $\alpha$ de 60°

Dans le cas où deux champs RF sont appliqués, il est possible d'obtenir les composantes du champ ambiant suivants les trois axes comme décrit dans l'article de Morales et al. cité précédemment. Le pompage engendré par le faisceau de sonde se traduit alors par des déformations des trois signaux correspondant aux trois composantes du champ. Dans ce cas, l'angle $\alpha$ permettant d'annuler le décalage du zéro ne peut pas se calculer avec une expression aussi simple que celle présentée plus haut, car l'amplitude des différents champs RF joue également un rôle. Cependant des nombreux tests montrent qu'il est toujours possible expérimentalement de trouver un angle qui redonne aux trois signaux une forme dispersive parfaite. Il est également envisageable de ne trouver des compromis pour ne redonner une forme dispersive qu'à un seul axe (ou deux) à la fois.

Ce principe d'ajustement de l'angle entre les directions de polarisation linéaires des faisceaux de pompe et de sonde reste valable pour la configuration du magnétomètre à effet Hanle pour lequel la mesure est une mesure d'absorption. Pour mesurer la composante du champ magnétique selon l'axe z, il faut également ajuster l'angle α de sorte qu'il respecte l'équation donnée précédemment et le critère $\Gamma_s \leq T_p$.

Lorsque le magnétomètre est du type à effet Hanle, le détecteur 6 est configuré pour réaliser une mesure d'absorption du faisceau de sonde lors de la traversée de la cellule.

Lorsque le magnétomètre est du type à résonance paramétrique, le détecteur 6 comprend un analyseur de polarisation configuré pour réaliser une mesure différentielle de la polarisation circulaire droite σ+ et de la polarisation circulaire gauche α- du faisceau de sonde ayant traversée la cellule. Le détecteur 6 vient ainsi délivrer, en tant que signal porteur d'une information relative à l'état d'alignement des atomes du gaz atomique dans la cellule, un signal représentatif de la différence des intensités des polarisations circulaires droite et gauche. Ce signal dépend uniquement de la composante du champ magnétique selon l'axe z et présente, comme représenté par la courbe en trait plein sur la figure 3, la forme d'une courbe lorentzienne dispersive centrée en champ nul. On notera qu'on s'intéresse de plus ici à la partie du signal optique modulée à la fréquence du champ radiofréquence d'excitation de la résonance paramétrique.

L'analyseur de polarisation peut notamment être configuré pour réaliser une séparation spatiale des polarisations circulaires droite et gauche du faisceau de sonde ayant traversé la cellule. A cet effet, l'analyseur de polarisation peut comprendre une lame quart d'onde, un cube séparateur de polarisations apte à séparer sur un premier et un deuxième chemin la polarisation circulaire droite et la polarisation circulaire gauche de la contribution de sonde ayant traversée la cellule et un photodétecteur sur chacun des premier et deuxième chemins.

Lorsque le magnétomètre est opéré en effet Hanle, il peut par ailleurs comprendre un modulateur du faisceau de sonde. Le faisceau de sonde peut ainsi être modulé en amplitude, en polarisation, voire en longueur d'onde dans un mode dégradé d'implémentation d'une modulation d'amplitude. La fréquence de modulation peut être suffisamment élevée, par exemple de l'ordre de 30 kHz, pour s'affranchir des problématiques de bruit basse fréquence du laser fournissant le faisceau de sonde, sans pour autant perdre en amplitude de signal. Le modulateur du faisceau de sonde peut également être un modulateur de polarisation, par exemple un modulateur photo-acoustique, agencé entre la cellule de mesure et le détecteur.

L'invention porte également sur un procédé de mesure d'un champ magnétique à l'aide du magnétomètre tel que précédemment décrit. Ce procédé comprend notamment les étapes consistant à polariser linéairement le faisceau de pompe selon une direction de polarisation, et à polariser linéairement le faisceau de sonde selon une direction de polarisation qui fait un angle non nul avec la direction de polarisation du faisceau de pompe.

## Revendications

1. Magnétomètre (10) comprenant une cellule (1) remplie d'un gaz atomique, une source optique (2, 3, 11-13) configurée pour éclairer la cellule avec un faisceau de pompe (Fp) et un faisceau de sonde (Fs) et un dispositif de photo-détection (6) agencé de manière à recevoir la lumière du faisceau de sonde ayant traversée la cellule et configuré pour délivrer un signal porteur d'une information relative à l'état d'alignement des atomes du gaz atomique dans la cellule, **caractérisé en ce que** le faisceau de pompe (Fp) est polarisé linéairement selon une direction de polarisation et le faisceau de sonde (Fs) est polarisé linéairement selon une direction de polarisation faisant un angle non nul (α) avec la direction de polarisation du faisceau de pompe.

2. Magnétomètre selon la revendication 1, dans lequel le faisceau de sonde se propage selon l'axe z d'un trièdre Oxyz, le faisceau de pompe est polarisé linéairement selon l'axe x du trièdre et le faisceau de pompe est polarisé linéairement dans le plan Oxy en faisant ledit angle non nul (α) avec l'axe x.

3. Magnétomètre selon l'une des revendications 1 et 2, dans lequel ledit angle non nul (α) est choisi de manière à ce que ce que le signal délivré par le dispositif de photo-détection (6) soit nul en présence d'un champ magnétique ambiant nul.

4. Magnétomètre selon l'une des revendications 1 et 2, dans lequel ledit angle non nul (α) est compris entre 45° et 90°.

5. Magnétomètre selon l'une des revendications 1 à 4, dans lequel le faisceau de pompe est accordé en longueur d'onde au centre d'une première raie atomique et le faisceau de sonde est accordé en longueur d'onde de manière à être décalé du centre d'une deuxième raie atomique différente de la première raie atomique en étant par exemple accordé au maximum de la partie imaginaire du profil de Voigt de la deuxième raie atomique.

6. Magnétomètre selon l'une des revendications 1 à 4, dans lequel le faisceau de pompe est accordé en longueur d'onde au centre d'une première raie atomique et le faisceau de sonde est accordé en longueur d'onde de manière à être décalé du centre de la première raie atomique en étant par exemple accordé en longueur d'onde au maximum de la partie imaginaire du profil de Voigt de la première raie atomique.

7. Magnétomètre selon l'une des revendications 1 à 6, comprenant en outre une source d'excitation de résonance paramétrique (7, 8) et dans lequel le dispositif de photo-détection (6) comprend un analyseur de polarisation configuré pour réaliser une mesure différentielle de la polarisation circulaire droite et de la polarisation circulaire gauche du faisceau de sonde ayant traversée la cellule.

8. Magnétomètre selon la revendication 7, dans lequel l'analyseur de polarisation comprend une lame quart d'onde, un cube séparateur de polarisations apte à séparer sur un premier et un deuxième chemin la polarisation circulaire droite et la polarisation circulaire gauche de la contribution de sonde ayant traversée la cellule et un photodétecteur sur chacun des premier et deuxième chemins.

9. Magnétomètre selon l'une des revendications 1 à 4, dans lequel le dispositif de photo-détection est configuré pour réaliser une mesure d'absorption du faisceau de sonde lors de la traversée de la cellule.

10. Magnétomètre selon l'une des revendications 1 à 9, comprenant en outre un modulateur du faisceau de sonde.

11. Procédé de mesure d'un champ magnétique à l'aide d'un magnétomètre (10) comprenant une cellule (1) remplie d'un gaz atomique, une source optique (2, 3, 11-13) configurée pour éclairer la cellule avec un faisceau de pompe (Fp) et un faisceau de sonde (Fs) et un dispositif de photo-détection (6) agencé de manière à recevoir la lumière du faisceau de sonde ayant traversée la cellule et configuré pour délivrer un signal porteur d'une information relative à l'état d'alignement des atomes du gaz atomique dans la cellule, le procédé comprenant les étapes consistant à :

    - polariser linéairement le faisceau de pompe (Fp) selon une direction de polarisation, et
    - polariser linéairement le faisceau de sonde (Fs) selon une direction de polarisation qui fait un angle non nul avec la direction de polarisation du faisceau de pompe.

FIG. 1

FIG. 2

FIG. 3

FIG. 4

Europäisches
Patentamt

European
Patent Office

Office européen
des brevets

**RAPPORT DE RECHERCHE EUROPEENNE**

Numéro de la demande

EP 19 20 8978

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | HIGBIE J M ET AL: "Robust, High-speed, All-Optical Atomic Magnetometer", ARXIV.ORG, CORNELL UNIVERSITY LIBRARY, 201 OLIN LIBRARY CORNELL UNIVERSITY ITHACA, NY 14853, 6 septembre 2006 (2006-09-06), XP080253575, DOI: 10.1063/1.2370597 * page 2 - page 4; figures 1, 2 * | 1-11 | INV. G01R33/24 |
| A,D | J. C. ALLRED ET AL: "High-Sensitivity Atomic Magnetometer Unaffected by Spin-Exchange Relaxation", PHYSICAL REVIEW LETTERS, vol. 89, no. 13, 9 septembre 2002 (2002-09-09), XP055607368, US ISSN: 0031-9007, DOI: 10.1103/PhysRevLett.89.130801 * le document en entier * | 1-11 | |
| A,D | MORALES S ET AL: "Magnetocardiography measurements withHe vector optically pumped magnetometers at room temperature", PHYSICS IN MEDICINE AND BIOLOGY, INSTITUTE OF PHYSICS PUBLISHING, BRISTOL GB, vol. 62, no. 18, 21 août 2017 (2017-08-21), pages 7267-7279, XP020319607, ISSN: 0031-9155, DOI: 10.1088/1361-6560/AA6459 [extrait le 2017-08-21] * le document en entier * | 1-11 | **DOMAINES TECHNIQUES RECHERCHES (IPC)**<br><br>G01R |

Le présent rapport a été établi pour toutes les revendications

| Lieu de la recherche | Date d'achèvement de la recherche | Examinateur |
|---|---|---|
| Munich | 6 avril 2020 | Raguin, Guy |

EPO FORM 1503 03.82 (P04C02)

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **J. DUPONT-ROC.** Détermination par des méthodes optiques des trois composantes d'un champ magnétique très faible. *Revue de Physique Appliquée,* 1970, vol. 5 (6), 853-864
- **MORALES et al.** Magnetocardiography measurements with 4He vector optically pumped magnetometers at room temperature. *Phys. Med. Biol.,* 2017, vol. 62, 7267

- **J. C. ALLRED et al.** High-Sensitivity Atomic Magnetometer Unaffected by Spin-Exchange Relaxation. *Phys. Rev. Lett.,* Septembre 2002, vol. 89 (13), 130801